# EUROPÄISCHE PATENTSCHRIFT

(11) **EP 2 376 949 B1**
(45) Veröffentlichungstag und Bekanntmachung des Hinweises auf die Patenterteilung: **07.08.2013**
(21) Anmeldenummer: 09799064.2
(22) Anmeldetag: 07.12.2009
(51) Int. Cl.: G01V 3/08, G01V 3/15

(54) **ORTUNGSVORRICHTUNG**
POSITION-FINDING APPARATUS
DISPOSITIF DE LOCALISATION

(30) Priorität: 10.12.2008 DE 102008054460
(43) Veröffentlichungstag der Anmeldung: 19.10.2011
(73) Patentinhaber: Robert Bosch GmbH, 70442 Stuttgart (DE)
(72) Erfinder: KRAPF, Reiner, 72770 Reutlingen (DE); HAASE, Bjoern, 70184 Stuttgart (DE); RENZ, Kai, 70771 Leinfelden-Echterdingen (DE)
(86) Internationale Anmeldenummer: PCT/EP2009/066477
(87) Internationale Veröffentlichungsnummer: WO 2010/066659

(56) Entgegenhaltungen:
- WO-A1-03/073130
- DE-A1- 3 600 446
- US-A- 5 917 314
- US-A1- 2003 218 469
- US-A1- 2005 194 959
- US-B1- 6 211 662

## Beschreibung

### Stand der Technik

Die Erfindung geht aus von einer Ortungsvorrichtung nach dem Oberbegriff des Anspruchs 1.

Aus der DE 3600446 A1 ist bereits eine Ortungsvorrichtung, insbesondere ein handgeführtes Ortungsgerät, bekannt. Die Ortungsvorrichtung weist eine Ortungseinheit, die zu einer Erfassung eines Vorhandenseins eines in einem Untersuchungsobjekt angeordneten Gegenstands mittels eines Messsignals vorgesehen ist und die eine Sensoreinheit und eine Recheneinheit aufweist, und eine Anzeigeeinheit auf. Ähnliche Ortungsvorrichtungen kennt der Fachmenn aus US 2005/0194959 A1 und US 5917314.

### Offenbarung der Erfindung

Die Erfindung geht aus von einer Ortungsvorrichtung, insbesondere ein handgeführtes Ortungsgerät, mit einer Ortungseinheit, die zu einer Erfassung eines Vorhandenseins eines in einem Untersuchungsobjekt angeordneten Gegenstands mittels eines Messsignals vorgesehen ist und die eine Sensoreinheit und eine Recheneinheit aufweist, und einer Anzeigeeinheit.

Es wird vorgeschlagen, dass die Recheneinheit dazu vorgesehen ist, differierenden Anzeigepunkten der Anzeigeeinheit differierende Sensorelemente der Sensoreinheit entlang zumindest einer Dimension zuzuordnen. In diesem Zusammenhang soll unter "vorgesehen" insbesondere speziell ausgestattet und/oder speziell ausgelegt und/oder speziell programmiert verstanden werden. Des Weiteren soll unter einer "Recheneinheit" insbesondere eine Einheit verstanden werden, die von einer Auswerteeinheit und/oder einer Signalverarbeitungseinheit gebildet sein kann, wobei die Recheneinheit sowohl von einem Prozessor allein als auch insbesondere von einem Prozessor und weiteren Elektronikbauteilen, wie beispielsweise einem Speichermittel, gebildet sein kann. Besonders vorteilhaft kann die Recheneinheit einen Mikrokontroller oder eine digitale Datenauswertung aufweisen, wobei vorteilhafterweise ein Analog-DigitalWandler dem Mikrokontroller und/oder der digitalen Datenauswertung vorgeschaltet angeordnet ist. Unter einer "Anzeigeeinheit" soll in diesem Zusammenhang eine Einheit zu einer optischen Informationsausgabe und/oder einer optischen Informations-übermittlung an einen Bediener des Ortungsgeräts verstanden werden, wie beispielsweise eine von einem Display und/oder einem Bildschirm gebildete Anzeigeeinheit. Des Weiteren soll unter einem "Anzeigepunkt" insbesondere ein Punkt und/oder ein Bereich, insbesondere ein Anzeigebereich, der Anzeigeeinheit verstanden werden, der von einem Pixel und/oder einem Segment der Anzeigeeinheit und/oder von einer Zusammenschaltung von mehreren Pixeln und/oder Segmenten gebildet ist. Vorzugsweise weist die Sensoreinheit mehrere Sensorelemente auf, die jeweils zu einem separaten Messen und/oder Erfassen von Messsignalen vorgesehen sind. Die Sensorelemente können von allen, dem Fachmann als sinnvoll erscheinenden Sensoren gebildet sein. Besonders vorteilhaft jedoch sind die einzelnen Sensorelemente als kapazitive Sensoren zur Erfassung einer Dielektrizitätskonstante ausgebildet. Eine Anordnung der Sensorelemente und/oder Anzeigepunkte zueinander kann zudem sowohl symmetrisch als auch unsymmetrisch sein. Grundsätzlich können die einzelnen Sensorelemente den einzelnen Anzeigebereichen beliebig zugeordnet werden. Besonders vorteilhaft ist jedoch eine fixe Zuordnung der Sensorelemente zu den Anzeigebereichen vorgesehen. Es kann durch diese erfindungsgemäße Ausgestaltung besonders vorteilhaft eine Anzeige von Gegenständen für einen Bediener der Ortungsvorrichtung erreicht bzw. ein vorteilhaftes Abbild in zumindest einer Dimension des Untersuchungsobjekts angezeigt werden. Zudem kann hierbei ein hoher Bedienkomfort, insbesondere ein Ablesekomfort der Messergebnisse, für einen Bediener erreicht werden.

Des Weiteren wird vorgeschlagen, dass eine Anzahl von Sensorelementen der Sensoreinheit im Wesentlichen gleich einer Anzahl von Anzeigepunkten der Anzeigeeinheit in zumindest einer Dimension ist. Es kann hierbei ein Messergebnis der Sensoreinheit hoch aufgelöst für den Bediener ausgegeben werden und somit ein detailliertes Abbild des Untersuchungsobjekts vorteilhaft erreicht werden. Vorzugsweise sind die unterschiedlichen Sensorelemente der Sensoreinheit jeweils von einem kapazitiven Sensor gebildet, wobei die einzelnen Sensorelemente sowohl als Messsensor als auch als Signalerzeugungssensor verwendet werden können, wobei eine Funktionsweise der einzelnen Sensorelemente von einer Ansteuerung und/oder einer Verschaltung der Sensoreinheit abhängig ist. Besonders vorteilhaft weist das Sensorarray zumindest 3x3 Sensorelemente auf, wobei eine Ortsauflösung der Ortungseinheit mit einer Anzahl der Sensorelemente steigt.

Weiterhin wird vorgeschlagen, dass die Anzeigeeinheit von einer zweidimensionalen Anzeigeeinheit gebildet ist, die dazu vorgesehen ist, ein Abbild des Untersuchungsobjekts in zwei Dimensionen auszugeben. In diesem Zusammenhang soll unter einem "Abbild" insbesondere ein Bild des Untersuchungsobjekts, insbesondere einer zu untersuchenden Wand, verstanden werden, das vorzugsweise von einer Projektion einer dreidimensionalen Struktur und/oder eines dreidimensionalen Profils des Untersuchungsobjekts auf eine zweidimensionale Fläche gebildet ist. Grundsätzlich ist jedoch eine Projektion der dreidimensionalen Struktur und/oder des dreidimensionalen Profils des Untersuchungsobjekts zu einem eindimensionalen Abbild denkbar, insbesondere mit einer Tiefenanzeige, die durch einen variierenden Abstand von insbesondere einzelnen Sensorelementen und/oder eines Elektrodenabstands von als Kapazitivelektroden ausgebildeten Sensorelementen ermöglicht werden kann. Vorzugsweise erstrecken sich die zwei Dimensionen entlang zweier Richtungen, die insbesondere im Wesentlichen senkrecht zueinander ausgerichtet sind. Das Abbild, insbesondere das zweidimensionale Abbild, ist vorzugsweise parallel zu einer Oberfläche des Untersuchungsobjekts, insbesondere einer Wandoberfläche, ausgerichtet. Durch diese Ausgestaltung der Erfindung kann vorteilhaft eine bildliche Darstellung des Untersuchungsobjekts für einen Bediener erreicht werden und damit einhergehend eine einfache Erkennung von erfassten Gegenständen innerhalb des Untersuchungsobjekts erzielt werden.

Es wird zudem vorgeschlagen, dass die Recheneinheit dazu vorgesehen ist, zumindest zwei Messwerte bei einer zweidimensionalen Erfassung mittels der Sensoreinheit zu einem Wert entlang einer Dimension zusammenzufassen. Vorzugsweise werden die zumindest zwei Messwerte von unterschiedlichen Sensorelementen entlang der einen Dimension erfasst. Die Recheneinheit ermittelt vorteilhafterweise den Wert aus den zumindest zwei Messwerten mittels einer Mittelwertberechnung. Es kann hierbei eine besonders kostengünstige Anzeigeeinheit für eine vorteilhafte Anzeige oder Ausgabe von Messergebnissen für den Bediener zur Verfügung gestellt werden. Des Weiteren kann eine eindimensionale Darstellung und/oder ein eindimensionales Abbild des Untersuchungsobjekts zumindest teilweise mit einem zweidimensionalen Informationsgehalt für den Bediener der Ortungsvorrichtung ausgegeben werden.

In einer vorteilhaften Weiterbildung der Erfindung wird vorgeschlagen, dass die Sensoreinheit eine Vielzahl von Sensorelementen aufweist, die in einem Sensorarray angeordnet sind. In diesem Zusammenhang soll unter einem "Sensorarray" insbesondere eine Anordnung der einzelnen Sensorelemente zueinander verstanden werden, wobei die Sensorelemente in Reihen und in Spalten und/oder in einer Matrixstruktur und/oder in einer Gitterstruktur und/oder in einer Rasterstruktur und/oder in weiteren, dem Fachmann als sinnvoll erscheinenden Anordnungen angeordnet sind. Vorteilhafterweise ist dem Sensorarray ein Anzeigearray der Anzeigeeinheit zugeordnet. Vorzugsweise können die unterschiedlichen Sensorelemente der Sensoreinheit sowohl als Messsensor als auch als Signalerzeugungssensor verwendet werden, wobei eine Funktionsweise der einzelnen Sensorelemente von einer Ansteuerung und/oder einer Verschaltung der einzelnen Sensorelemente abhängig ist. Besonders vorteilhaft weist das Sensorarray zumindest 3x3 Sensorelemente auf, wobei eine Ortsauflösung der Ortungseinheit mit einer Anzahl der Sensorelemente steigt. Es kann durch diese Anordnung der einzelnen Sensorelemente der Sensoreinheit ein vorteilhaftes Abscannen bzw. eine vorteilhafte Informationserfassung einer inneren Struktur des Untersuchungsobjekts erreicht werden. Ferner können hierbei eine Anordnung und/oder ein Verlauf und/oder eine Orientierung und/oder eine Form eines Gegenstands in dem Untersuchungsobjekt detailliert erfasst werden und diese Information mittels der Anzeigeeinheit detailliert an den Bediener ausgegeben werden. Des Weiteren kann eine Erfassung eines Gegenstands, der insbesondere entlang zumindest einer Dimension kleiner ist als die Ortungsvorrichtung bzw. die Sensoreinheit, in dem Untersuchungsobjekt mittels einer statischen und/oder einer ortsfesten Positionierung der Ortungsvorrichtung auf dem Untersuchungsobjekt erreicht werden und es kann auf ein Verfahren der Ortungsvorrichtung für eine Erfassung zumindest teilweise verzichtet werden._Vorzugsweise wird eine Darstellung und/oder eine Anzeige der Anzeigeeinheit abhängig von einem Messzyklus der Sensoreinheit aktualisiert. Es kann hierbei die Darstellung und/oder die Anzeige der Anzeigeeinheit nach einem Messzyklus oder nach mehreren Messzyklen aktualisiert werden, wobei hier eine Mittelung von Messwerten über die mehreren Messzyklen erforderlich sein kann. Vorteilhafterweise erfolgt eine Aktualisierung der Anzeige in einem Bereich von ca. 10 Hz.

In einer vorteilhaften Weiterbildung der Erfindung wird vorgeschlagen, dass die Recheneinheit dazu vorgesehen ist, die Sensorelemente entlang zumindest einer Dimension nacheinander für eine Messung zu aktivieren, wodurch eine hohe Ortsauflösung während eines Messbetriebs der Ortungsvorrichtung vorteilhaft erreicht werden kann. Unter "aktiviert" soll hierbei insbesondere verstanden werden, dass die Sensorelemente einzeln für eine Messung und/oder einen Messbetrieb ausgewählt und/oder angesteuert werden und bei einer Messung durch ein weiteres Sensorelement von der Recheneinheit deaktiviert werden können. Eine Aktivierung der Sensorelemente kann hierbei entlang einer Reihe und/oder einer Spalte des Sensorarrays erfolgen.

Des Weiteren wird vorgeschlagen, dass die Recheneinheit dazu vorgesehen ist, einen gleich bleibenden Abstand zwischen zwei variierenden, aktivierten Sensorelementen einzustellen, wodurch ein hochauflösendes Abscannen des Untersuchungsobjekts mit einer im Wesentlichen gleich bleibenden Eindringtiefe des Messsignals in das Untersuchungsobjekt erreicht werden kann. Zudem kann hierbei ein vorteilhaftes Signal-Rauschverhältnis erreicht werden und/oder ein vorteilhafter Schwellenwert für eine Anzeige der Anzeigeeinheit, insbesondere automatisch, eingestellt werden.

Es wird ferner vorgeschlagen, dass die Recheneinheit dazu vorgesehen ist, einen variierenden Abstand zwischen zwei zumindest teilweise variierenden, aktivierten Sensorelementen einzustellen. Es kann hierbei eine vorteilhafte Tiefeninformation des Untersuchungsobjekts und insbesondere eine Positionierung eines in dem Untersuchungsobjekt angeordneten Gegenstands mit einem Abstand des Gegenstands zu einer Oberfläche des Untersuchungsobjekts für einen Bediener erreicht werden. Vorzugsweise kann diese Information von dem Bediener über die Anzeigeeinheit abgerufen werden, wie beispielsweise indem die Ortungseinheit ein Betätigungselement aufweist, mittels dessen ein Umschalten der Anzeigeeinheit in einen Anzeigemodus mit einer Tiefeninformation möglich ist.

Zudem wird vorgeschlagen, dass die Recheneinheit dazu vorgesehen ist, zumindest eines der Sensorelemente als Messelektrode oder als Signalerzeugungselektrode zu aktivieren, wodurch vorteilhaft ein flexibles Messen und insbesondere ein hohes Auflösungsvermögen der Sensoreinheit erreicht werden kann. Vorzugsweise ist die Messelektrode zu einem Messen oder einem Erfassen des Messsignals vorgesehen und die Signalerzeugungselektrode zu einem Erzeugen oder einem Anlegen eines Signals, insbesondere eines von einem elektrischen Feld, wie beispielsweise einem statischen Feld oder besonders vorteilhaft einem Wechselfeld, gebildeten Signals, vorgesehen.

In einer weiteren Ausgestaltung der Erfindung wird ein Verfahren, insbesondere mit einer Ortungsvorrichtung, vorgeschlagen, wobei differierenden Anzeigepunkten einer Anzeigeeinheit differierende Sensorelemente einer Sensoreinheit entlang zumindest einer Dimension zugeordnet werden. Es kann besonders vorteilhaft eine Anzeige von insbesondere Gegenständen für einen Bediener der Ortungsvorrichtung erreicht werden und/oder ein vorteilhaftes Abbild in zumindest einer Dimension des Untersuchungsobjekts angezeigt werden. Zudem kann hierbei ein hoher Bedienkomfort, insbesondere ein Ablesekomfort der Messergebnisse, für einen Bediener erreicht werden.

Des Weiteren wird vorgeschlagen, dass ein Abbild eines Untersuchungsobjekts mittels der Anzeigeeinheit entlang zumindest einer Dimension angezeigt wird. Besonders vorteilhaft wird jedoch ein zweidimensionales Abbild des Untersuchungsobjekts mittels der Anzeigeeinheit angezeigt. Es kann vorteilhaft eine bildliche Darstellung des Untersuchungsobjekts für einen Bediener erreicht werden und damit einhergehend eine einfache Erkennung von erfassten Gegenständen innerhalb des Untersuchungsobjekts erzielt werden.

Es wird ferner vorgeschlagen, dass eine Orientierung eines Gegenstands mittels der Anzeigeeinheit angezeigt wird, wodurch eine vorteilhafte Gegenstandserkennung für einen Bediener erreicht werden kann. Unter einer "Orientierung eines Gegenstands" soll hierbei eine räumliche Ausrichtung einer Achse, insbesondere einer Längsachse, des Gegenstands bezüglich des Untersuchungsobjekts und/oder einer auf den Gegenstand wirkenden Schwerkraft verstanden werden. Vorteilhafterweise kann hierbei eine formabhängige Ortung von Gegenständen erzielt werden, indem eine Gegenstandsauswahl gezielt auf beispielsweise Schrauben, Leitungen usw. gerichtet werden kann, wobei die formabhängige Ortung vorzugsweise automatisch mittels einer Recheneinheit erfolgen kann.

Zudem wird vorgeschlagen, dass ein gleich bleibender Abstand zwischen zwei variierenden, aktivierten Sensorelementen einer Sensoreinheit eingestellt wird, wodurch ein hochauflösendes Abscannen des Untersuchungsobjekts mit einer im Wesentlichen gleich bleibenden Eindringtiefe des Messsignals in das Untersuchungsobjekt erreicht werden kann. Zudem kann hierbei ein vorteilhaftes Signal-Rauschverhältnis erreicht werden und/oder ein vorteilhafter Schwellenwert für eine Anzeige der Anzeigeeinheit, insbesondere automatisch, eingestellt werden.

Es wird ferner vorgeschlagen, dass ein variierender Abstand zwischen zwei zumindest teilweise variierenden, aktivierten Sensorelementen eingestellt wird, wodurch eine vorteilhafte Tiefeninformation des Untersuchungsobjekts, insbesondere eine Objekttiefe, und insbesondere eine Positionierung eines in dem Untersuchungsobjekt angeordneten Gegenstands mit einem Abstand des Gegenstands zu einer Oberfläche des Untersuchungsobjekts für einen Bediener erreicht werden kann. Vorteilhafterweise wird die derart ermittelte Tiefeninformation des Untersuchungsobjekts, insbesondere die Objekttiefe, mittels der Anzeigeeinheit für einen Bediener des Ortungsgeräts dargestellt.

### Zeichnung

Weitere Vorteile ergeben sich aus der folgenden Zeichnungsbeschreibung. In der Zeichnung sind Ausführungsbeispiele der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: ein Ortungsgerät mit einer Ortungseinheit in einer schematischen Ansicht,
- Fig. 2: das Ortungsgerät zusammen mit einem Untersuchungsobjekt in einer schematischen Ansicht,
- Fig. 3: eine Sensoreinheit und eine Anzeigeeinheit des Ortungsgeräts in einer schematischen Ansicht,
- Fig. 4a - 4i: die Sensoreinheit mit einem gleich bleibenden Abstand zwischen zwei variierenden Sensorelementen mit unterschiedlichen aktivierten Sensorelementen in einer schematischen Ansicht,
- Fig. 5a, 5b: die Sensoreinheit mit einer Zusammenschaltung von mehreren Sensorelementen in einer schematischen Ansicht,
- Fig. 6: die Sensoreinheit mit unbeschalteten Sensorelementen in einer schematischen Ansicht,
- Fig. 7a - 7d: die Anzeigeeinheit mit unterschiedlichen Darstellungsvarianten von Gegenständen in einer schematischen Ansicht,
- Fig. 8a - 8c: die Sensoreinheit mit einem variierenden Abstand zwischen zwei Sensorelementen in einer schematischen Ansicht,
- Fig. 9: eine Anordnung der Sensoreinheit mit einem variierenden Detektionsradius in einer schematischen Ansicht,
- Fig. 10a - 10c: die Sensoreinheit mit einem gleich bleibenden, zu Fig. 4a - 4i vergrößerten Abstand zwischen zwei variierenden Sensorelementen mit unterschiedlichen Messpunkten in einer schematischen Ansicht und
- Fig. 11: die Sensoreinheit und eine Anzeigeeinheit mit einer eindimensionalen Anzeige in einer schematischen Ansicht.

### Beschreibung der Ausführungsbeispiele

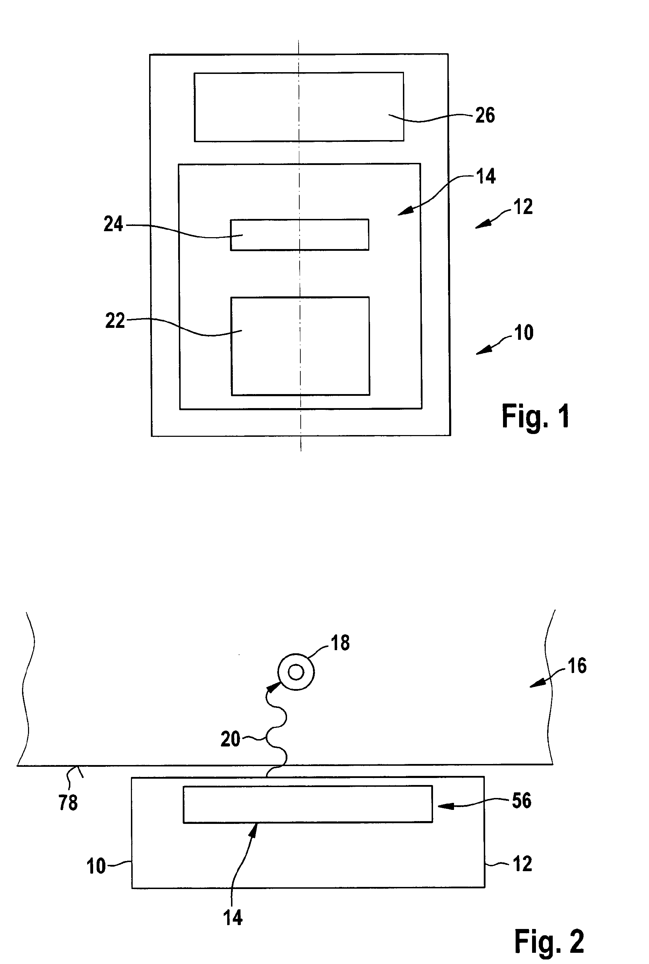

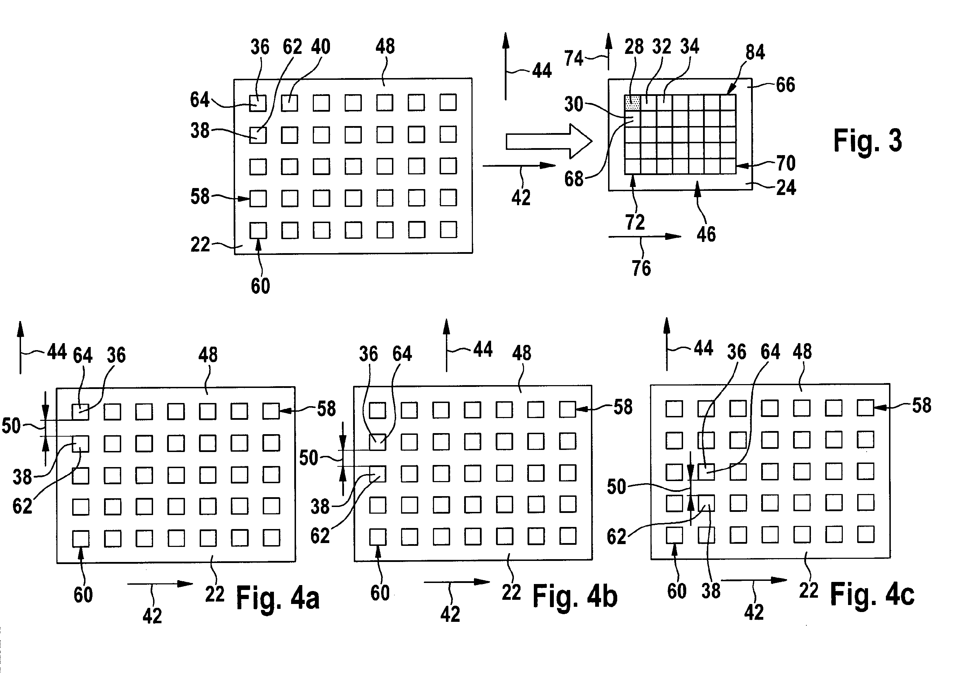

In den Figuren 1 und 2 ist eine von einem handgeführten Ortungsgerät 12 gebildete Ortungsvorrichtung 10 schematisch dargestellt. Das Ortungsgerät 12 weist eine Ortungseinheit 14 auf, die zu einer Erfassung eines Vorhandenseins eines in einem Untersuchungsobjekt 16, wie beispielsweise einer Wand, angeordneten Gegenstands 18 mittels eines Messsignals 20 vorgesehen ist. Hierzu weist die Ortungseinheit 14 eine Sensoreinheit 22 und eine Recheneinheit 24 auf, die zu einem Messen und/oder einem Erzeugen des Messsignals 20 und einem Auswerten eines gemessenen Signals vorgesehen sind. Des Weiteren weist das Ortungsgerät 12 eine Anzeigeeinheit 26 auf, die zu einer Anzeige von gemessenen Signalen und/oder von Messergebnissen und insbesondere von detektierten Gegenständen 18, wie beispielsweise eine in der Wand angeordnete Stromleitung und/oder Wasserleitung usw., vorgesehen ist. Die Recheneinheit 24 ist im Betrieb des Ortungsgeräts 12 dazu vorgesehen, differierenden Anzeigepunkten 28, 30, 32, 34 der Anzeigeeinheit 26 differierende Sensorelemente 36, 38, 40 der Sensoreinheit 22 entlang zumindest einer Dimension 42, 44 zuzuordnen (Figur 3).

Die Sensoreinheit 22 ist in einem dem Untersuchungsobjekt 16 zugewandten Bereich 56 des Ortungsgeräts 12 angeordnet und weist eine Vielzahl von Sensorelementen 36, 38, 40 auf, die jeweils von einem Kapazitivsensor gebildet sind. Die Sensoreinheit 22 weist zudem ein Sensorarray 48 auf, wobei die Sensorelemente 36, 38, 40 in Reihen 58 und Spalten 60 innerhalb des Sensorarrays 48 angeordnet sind (Figur 3). Die Sensorelemente 36, 38, 40 können eine Funktionsweise einer Messelektrode 62 als auch einer Signalerzeugungselektrode 64 innehaben, wobei dies von einer Ansteuerung der Sensorelemente 36, 38, 40 und/oder einer Verschaltung der Sensorelemente 36, 38, 40 abhängig ist. Die Signalerzeugungselektrode 64 ist zu einem Erzeugen eines Messsignals 20, insbesondere eines Wechselsignals, vorgesehen und die Messelektrode 62 zu einem Messen des Messsignals 20. In einem normalen Betriebsmodus der Ortungseinheit 14 können alle Sensorelemente 36, 38, 40 der Sensoreinheit 22 mit Ausnahme von zwei Sensorelementen 36, 38 mit einem Massepotential verbunden werden, so dass ausschließlich die zwei Sensorelemente 36, 38 für eine Messung zur Verfügung stehen. Das als Signalerzeugungselektrode 64 ausgebildete Sensorelement 36 wird anschließend mit einer Wechselspannung beaufschlagt und das als Messelektrode 62 ausgebildete Sensorelement 38 wird mittels eines nicht dargestellten Schaltmittels mit einem Eingang eines hochohmigen, nicht näher dargestellten Messverstärkers der Recheneinheit 24 verbunden.

Im Betrieb der Ortungseinheit 14 wird am Eingang des Messverstärkers eine Spannungskenngröße ermittelt, die ein Maß für eine kapazitive Verkopplung zwischen dem als Signalerzeugungselektrode 64 ausgebildeten Sensorelement 36 und dem als Messelektrode 62 ausgebildeten Sensorelement 38 ist. Mittels der Spannungskenngröße kann eine Änderung einer Dielektrizitätskenngröße in dem Untersuchungsobjekt 16 erfasst werden und es können hierbei Rückschlüsse auf in dem Untersuchungsobjekt 16 angeordnete Gegenstände 18 in der Recheneinheit 24 erfasst werden. Die Recheneinheit 24 ist zu einer Variation der beiden ausgewählten und für eine Messung aktivierten und angesteuerten Sensorelemente 36, 38, 40 vorgesehen. Aufgrund der arrayförmigen Anordnung der einzelnen Sensorelemente 36, 38, 40 wird ein von dem Ortungsgerät 12 überdeckter Bereich des Untersuchungsobjekts 16 mit einer hohen Ortsauflösung, die im Wesentlichen einem Abstand der einzelnen direkt zueinander benachbarten Sensorelemente 36, 38, 40 entspricht, abgescannt, wobei sich Feldlinien einer angelegten Spannung in das Untersuchungsobjekt 16 hineinerstrecken. Je nach Größe des Gegenstands 18 kann zu seiner Erfassung ein Verfahren des Ortungsgeräts 12 durch den Bediener entfallen, sofern das Ortungsgerät 12, insbesondere die Sensoreinheit 22, in zumindest einer Dimension 42, 44 eine größere Erstreckung als der Gegenstand 18 aufweist.

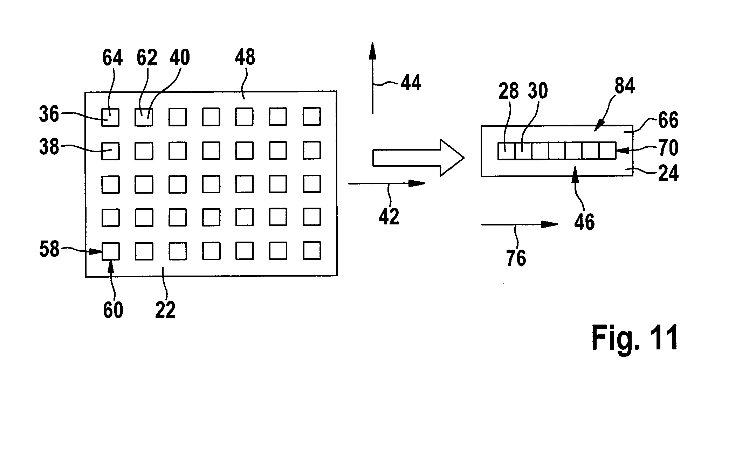

Die in Figur 3 dargestellte Anzeigeeinheit 26 weist eine Anzahl von Anzeigepunkten 28, 30, 32, 34 auf, die im Wesentlichen einer Anzahl von Sensorelementen 36, 38, 40 der Sensoreinheit 22 entspricht, so dass eine hochauflösende, detaillierte Anzeige und Ausgabe für einen Bediener im Betrieb des Ortungsgeräts 12 ermöglicht wird. Die Anzeigepunkte 28, 30, 32, 34 sind jeweils einem Sensorelement 36, 38, 40 der Sensoreinheit 22 zugeordnet._Die Anzeigeeinheit 26 ist hierbei von einem Display 66 gebildet, wobei die einzelnen Anzeigepunkte 28, 30, 32, 34 von Pixeln 68 des Displays 66 gebildet sind. Grundsätzlich könnten die Anzeigepunkte 28, 30, 32, 34 von Anzeigesegmenten und/oder von einer Zusammenschaltung von Pixeln und/oder Anzeigesegmenten gebildet sein. Eine Anordnung der einzelnen Anzeigepunkte 28, 30, 32, 34 zueinander entspricht einer Anordnung der einzelnen Sensorelemente 36, 38, 40 zueinander, wobei die Anzeigepunkte 28, 30, 32, 34 ebenfalls in Reihen 70 und Spalten 72 eines Anzeigearrays 84 angeordnet sind. Grundsätzlich könnten jedoch zwei oder mehr Sensorelemente 36, 38, 40 entlang einer Spalte 60 und/oder Reihe 58 des Sensorarrays 48 zusammengefasst werden und in einem Anzeigepunkt 28, 30, 32, 34 der Anzeigeeinheit 26 angezeigt werden. Des Weiteren können auch alle Sensorelemente 36, 38, 40 entlang einer Dimension 44, insbesondere einer Spalte 60, zusammengefasst werden und in einem Anzeigepunkt 28, 30, 32, 34 dargestellt werden, wie dies in Figur 11, einer Sensoreinheit 22 und einer alternativen Anzeigeeinheit 26 mit einem eindimensionalen Display 66 dargestellt ist. Hierbei werden mittels der Recheneinheit 24 einzelne Messwerte der Sensorelemente 36, 38, 40 einer Spalte 60 zu einem Wert gemittelt und auf einem Anzeigepunkt 28, 30, 32, 34 ausgegeben.

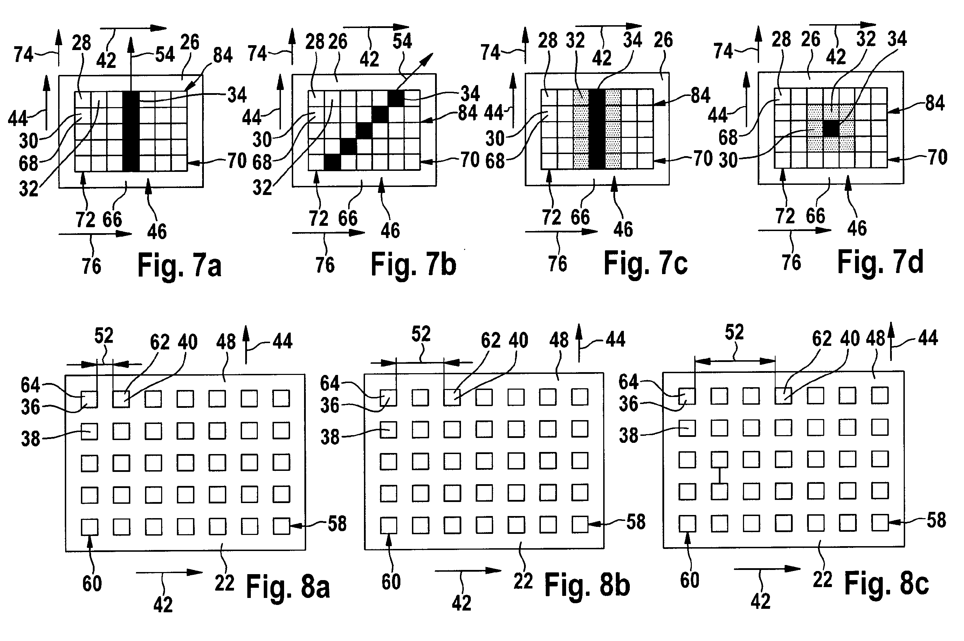

Mittels der zweidimensionalen Anzeigeeinheit 26 (Figuren 3 und 7a bis 7d) wird im Betrieb der Ortungseinheit 14 ein Abbild 46 des Untersuchungsobjekts 16 entlang zwei Dimensionen 42, 44 ausgegeben. Die zwei Dimensionen 42, 44 sind entlang zwei Richtungen 74, 76 ausgerichtet, die eine Oberfläche, insbesondere parallel zu einer Wandoberfläche 78 des Untersuchungsobjekts 16, aufspannen. Dieses von der Anzeigeeinheit 26 angezeigte Abbild 46 enthält eine dreidimensionale Information des Untersuchungsobjekts 16, indem eine innere Struktur, insbesondere das sich senkrecht zur Untersuchungsobjektoberfläche in das Untersuchungsobjekt 16 hinein erstreckende Profil des Untersuchungsobjekts 16 mit darin enthaltenen Gegenständen 18 auf das zweidimensionale Abbild 46 projiziert wird. Hierbei kann im Betrieb des Ortungsgeräts 12 ein in dem Untersuchungsobjekt 16 angeordneter Gegenstand 18 positionsgenau für einen Bediener angezeigt werden und zudem eine Ausrichtung und/oder eine Orientierung 54 des Gegenstands 18 angezeigt werden (Figuren 8a und 8b). Des Weiteren wird im Betrieb des Ortungsgeräts 12 zudem eine Breite des Gegenstands 18 und/oder eine Form zu einer Unterscheidung unterschiedlicher Gegenstände 18 auf dem Display 66 dargestellt.

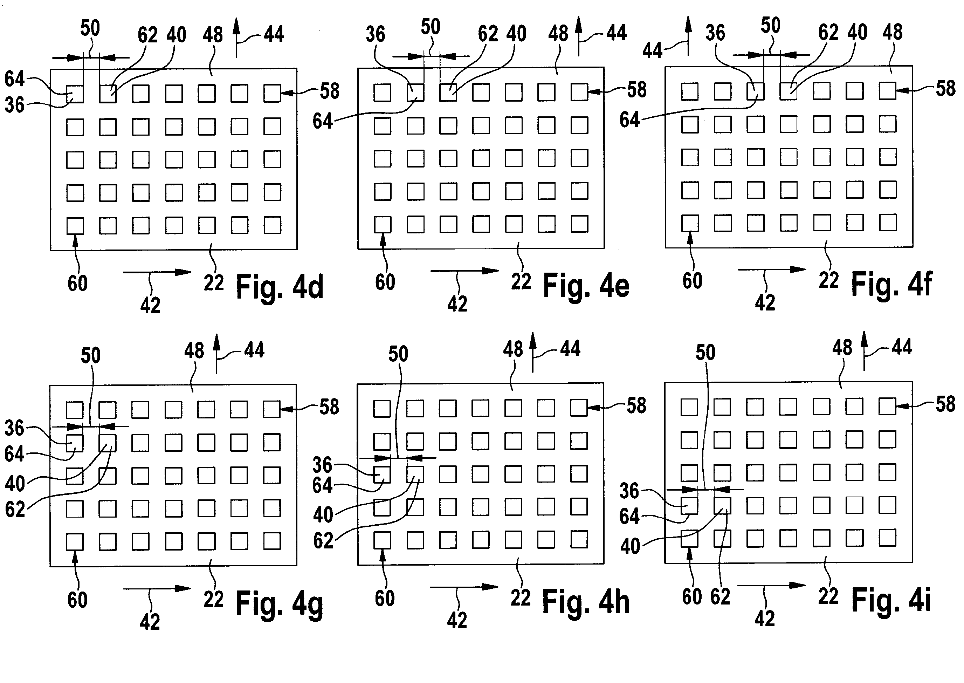

Die Ortungseinheit 14 weist zwei unterschiedliche Messmodi auf, die für eine Messung von einem Bediener beispielsweise über eine nicht dargestellte Tastatur ausgewählt werden können. In einem ersten Messmodus wird von der Recheneinheit 24 ein gleich bleibender Abstand 50 zwischen zwei variierenden, von der Recheneinheit 24 für eine Messung aktivierten und angesteuerten Sensorelementen 36, 38, 40 eingestellt. Die einzelnen, für eine Messung aktivierten und angesteuerten Paare von Sensorelementen 36, 38, 40 werden dabei von der Recheneinheit 24 nacheinander aktiviert (Figuren 4a bis 4i). Während der Messung wird die kapazitive Kopplung und/oder werden die Messsignale 20 dominant von Oberflächeneffekten der Wand beeinflusst, wobei diese Beeinflussung im Wesentlichen für alle Paare von Sensorelementen 36, 38, 40 gleich ist. Überdeckt dagegen ein Paar von Sensorelementen 36, 38, 40 einen in dem Untersuchungsobjekt 16 befindlichen Gegenstand 18, unterscheidet sich das Messsignal 20, insbesondere die kapazitive Kopplung, der beiden Sensorelemente 36, 38, 40 von Messsignalen weiterer Sensorelemente 36, 38, 40. Zu einer Signaltrennung eines Gegenstandssignals von Untergrundsignalen wird von der Recheneinheit 24 ein Mittelwert von den gemessenen Messsignalen 20 aller Sensorelemente 36, 38, 40 gebildet und dieser Mittelwert von den einzelnen Messsignalen abgezogen. Grundsätzlich ist es zudem denkbar, dass das Untergrundsignal durch eine explizite Untergrundmessung, beispielsweise an einem homogenen Untersuchungsobjekt, erfolgen kann und/oder auf Basis von Werten in Form eines Korrekturfaktors einer Tabelle, die im Rahmen einer Werkskalibrierung für jedes Sensorelement 36, 38, 40 ermittelt und in der Recheneinheit 24 gespeichert wird. Sofern eine unerwünschte Dekalibrierung des Ortungsgeräts 12 stattgefunden hat, reicht es aus, dass das Ortungsgerät 12 vor einem Ortungsvorgang in die Luft gehalten wird, wobei eine selbsttätige Kalibrierung der Sensoreinheit 22 von der Recheneinheit 24 erfolgt.

Wird von der Recheneinheit 24 das Untergrundsignal von dem jeweiligen Messsignal 20 der Sensorelemente 36, 38, 40 abgezogen, ergibt sich eine Gegenstandssignalmatrix, die mittels der Anzeigeeinheit 26, insbesondere dem Display 66, für den Bediener angezeigt wird. Dabei können die einzelnen Anzeigepunkte 28, 30, 32, 34 mit unterschiedlichen Graustufen und/oder farbig dargestellt werden, um einen räumlichen Verlauf und oder eine Form der Gegenstände 18 anzuzeigen. Eine Ortung und Anzeige von in dem Untersuchungsobjekt 16 befindlichen Gegenständen kann hierbei selbst bei einer statischen Messung erfolgen, bei der ein Bewegen des Ortungsgeräts 12 unterbleiben kann, sofern der Gegenstand 18 in zumindest einer Dimension 42, 44 kleiner ist als die Sensoreinheit 22. Bei einem großflächigen Gegenstand 18 ist zur Untergrundbestimmung ein Hin- und Herbewegen bzw. ein Verfahren des Ortungsgeräts 12 über die Oberfläche des Untersuchungsobjekts 16 erforderlich.

Die Anzeigeeinheit 26 wird von der Recheneinheit 24 im Betrieb der Ortungseinheit 14 regelmäßig aktualisiert. Eine Aktualisierungsperiode entspricht dabei vorteilhafterweise einem Messzyklus des Sensorarrays 48 der Sensoreinheit 22. Innerhalb eines Messzykluses werden alle Sensorelemente 36, 38, 40 nacheinander für eine Messung aktiviert und/oder angesteuert, so dass ein vollständiges Abbild 46 des Untersuchungsobjekts 16 auf dem Display 66 angezeigt werden kann. Vorzugsweise kann die Aktualisierung auch an ein Bewegen der Ortungseinheit 14 über das Untersuchungsobjekt 16 angepasst werden, so dass dem Bediener ständig ein aktuelles Abbild 46 des Untersuchungsobjekts 16 mittels der Anzeigeeinheit 26 übermittelt wird. Eine Aktivierungsfrequenz beträgt hierbei vorteilhaft ca. 10 Hz.

Um eine Anzeige der Anzeigeeinheit 26 für den Bediener ruhig zu gestalten und/oder um Störungen während einer Anzeige und/oder einer Darstellung durch die Anzeigeeinheit 26 zu reduzieren, wird gegebenenfalls in der Recheneinheit 24 automatisch neben einem Mittelwertabzug zudem eine Inhomogenitätskenngröße in den erfassten Signalen ermittelt, welche eine Anzeigenschwelle der Anzeigeeinheit 26 beeinflusst. Hierbei wird ständig von der Recheneinheit 24 eine Differenz zwischen einem niedrigsten Messsignal 20 und einem höchsten Messsignal 20 ermittelt und nur Gegenstandssignale, die über dieser Schwelle liegen als solche von der Recheneinheit 24 erkannt und von der Anzeigeeinheit 26 ausgegeben. Eine Empfindlichkeit der Sensoreinheit 22 reduziert sich hierbei, jedoch werden unreproduzierbare Signale und/oder Anzeigen von der Recheneinheit 24 vorteilhaft unterdrückt. Diese dynamische Schwellenanpassung kann hierbei nach einem jeweiligen Messzyklus erfolgen und/oder über alle Messzyklen innerhalb eines bestimmten Zeitintervalls.

Eine Variation der aktivierten und angesteuerten Sensorelemente 36, 38, 40 kann entlang der ersten Dimension 42, insbesondere entlang einer Reihe 58 des Sensorarrays 48, oder entlang der zweiten Dimension 44, insbesondere entlang einer Spalte 60 des Sensorarrays 48, erfolgen (Figuren 4a bis 4i). Zudem ist die Recheneinheit 24 dazu vorgesehen, im Betrieb des Ortungsgeräts 12 die Paare von Sensorelementen 36, 38, 40 entlang der ersten Dimension 42 oder der zweiten Dimension 44 miteinander zu verschalten. Ferner kann zur Erfassung von Gegenständen 18 eine Orientierung eines Paars von Sensorelementen 36, 38, 40 geändert werden, so dass eine Information über eine Art und/oder eine Lage des Gegenstands 18 effektiv erfasst werden kann. So werden beispielsweise Paare von Sensorelementen 36, 38, 40 weit stärker von Leitungen beeinflusst, die eine Ausrichtung im Wesentlichen parallel zu den Paaren von Sensorelementen 36, 38, 40 aufweisen, als von Leitungen, die eine Ausrichtung im Wesentlichen quer zu der Ausrichtung des Paars der Sensorelemente 36, 38, 40 aufweisen.

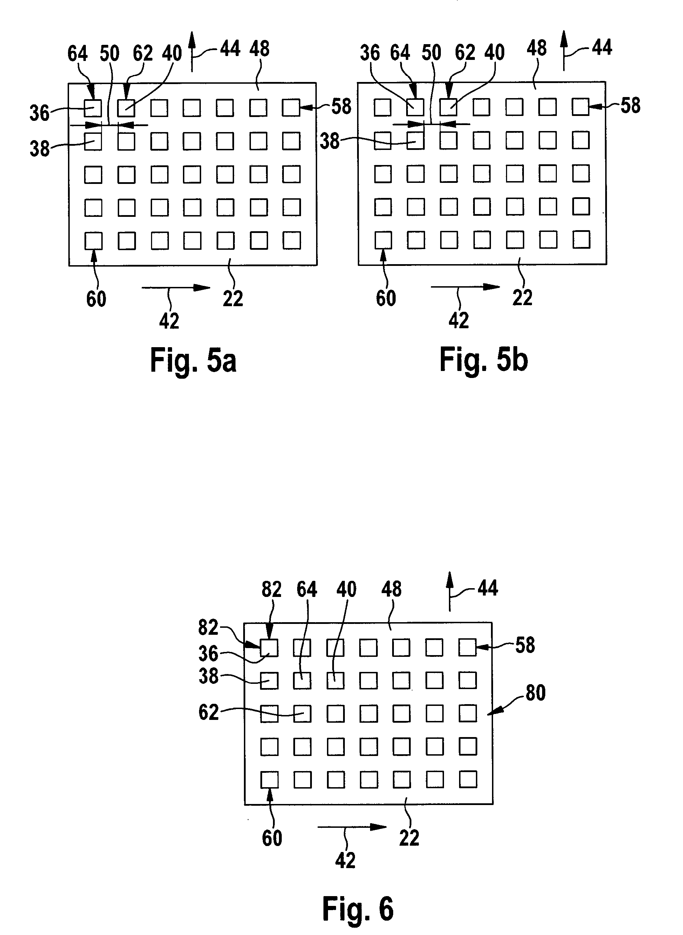

Eine Anordnung der Sensorelemente 36, 38, 40 in dem Sensorarray 48 kann sowohl symmetrisch als auch unsymmetrisch sein. Des Weiteren ist es denkbar, dass mehrere Sensorelemente 36, 38, 40, insbesondere eine Reihe 58 oder eine Spalte 60 von Sensorelementen 36, 38, 40, von der Recheneinheit 24 zusammengeschaltet werden und als eine Messelektrode 62 oder als eine Signalerzeugungselektrode 64 ausgebildet sind (Figuren 5a und 5b). Hierbei kann eine große Elektrodenfläche zur Erzeugung eines größeren Messsignals 20 erreicht werden. Des Weiteren ist die Recheneinheit 24 dazu vorgesehen, die Sensorelemente 36, 38 des Sensorarrays 48, die in einem äußeren Randbereich 80 des Sensorarrays 48 angeordnet sind, als Dummyelektroden 82 auszubilden, so dass eine gleichförmige Verkoppelungscharakteristik der restlichen Sensorelemente 40 erreicht wird (Figur 6). Die Dummyelektroden 82 sind verbindungslos, insbesondere elektrisch unleitend, zu den restlichen Sensorelementen 40 angeordnet.

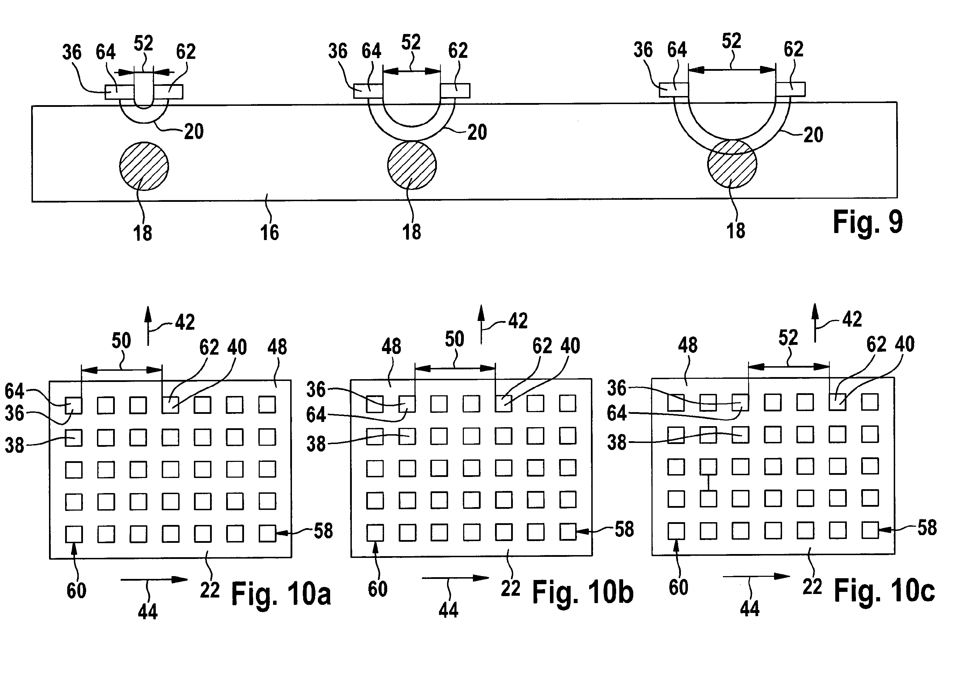

Zudem kann der Bediener im Betrieb des Ortungsgeräts 12 auf einen weiteren Messmodus umschalten. Der weitere Messmodus ermöglicht eine Ortungsmessung mit unterschiedlichen Eindringtiefen des Messsignals 20, so dass eine Tiefe des Gegenstands 18und/oder Tiefenposition des Gegenstands 18 ermittelt werden kann. Hierbei wird von der Recheneinheit 24 ein Abstand 52 zwischen zwei aktivierten und angesteuerten Sensorelementen 36, 38, 40 von einem Paar von Sensorelementen 36, 38, 40 zu einem zweiten Paar von aktivierten und angesteuerten Sensorelementen 36, 38, 40 variiert (Figuren 8a bis 9). Je größer der Abstand 52 zwischen den beiden aktivierten und angesteuerten Sensorelementen 36, 40, desto größer ist eine Eindringtiefe des Messsignals 20 und damit eine Reichweite eines von der Signalerzeugungselektrode 64 erzeugten Felds. Grundsätzlich ist ein automatisches Tiefenscannen des Untersuchungsobjekts 16 mittels Recheneinheit 24 jederzeit möglich. Zur Anzeige einer Positionstiefe des Gegenstands 18 kann von einem Bediener über die Tastatur ein Anzeigemodus umgeschaltet werden. Zudem kann auch ein Abscannen des Untersuchungsobjekts 16 mit einem großen Abstand 50 zwischen den einzelnen aktivierten und angesteuerten Sensorelementen 36, 38, 40 von der Recheneinheit 24 eingestellt werden, so dass über eine große Fläche eine Tiefeninformation des Untersuchungsobjekts 16 erfasst werden kann (Figuren 10a bis 10c).

Im Betrieb des Ortungsgeräts 12 kann ein Bediener einen weiteren Modus aktivieren, indem gezielt nach vorgegebenen Signalmustern bei einer Auswertung der Messzyklen automatisch von der Recheneinheit 24 gesucht wird und diese anschließend in der Anzeigeeinheit 26 für den Bediener angezeigt werden. Beispielsweise kann hierbei ein Gegenstandsmuster ausgewählt werden, wie insbesondere Rohre und/oder Leitungen und/oder Schrauben usw., wobei die Recheneinheit 24 ein Gesamtbild des Untersuchungsobjekts 16 generiert und das Gesamtbild nach dem vorgegebenen Gegenstandsmuster durchsucht und nur die entsprechenden Gegenstände 18 für den Bediener zur Anzeige bringt, so dass die entsprechenden Gegenstände 18 für einen Bediener einfach in der Anzeigeeinheit 26 zu erkennen sind, wie beispielsweise Signale von Gegenständen 18 bei einem unregelmäßigen Hintergrundsignal, wie dies insbesondere bei Hohllochbaustoffen, die zumindest teilweise dielektrisch inhomogen sind, von Vorteil sein kann.

## Patentansprüche

1. Ortungsvorrichtung, insbesondere handgeführtes Ortungsgerät (12),
mit einer Ortungseinheit (14), die zu einer Erfassung eines Vorhandenseins eines in einem Untersuchungsobjekt (16) angeordneten Gegenstands (18) mittels eines Messsignals (20) vorgesehen ist und die eine Sensoreinheit (22) sowie eine Recheneinheit (24) aufweist,
sowie mit einer Anzeigeneinheit,
wobei die Sensoreinheit (22) eine Vielzahl von Sensorelementen (36, 38, 40) aufweist, die in einem Sensorarray (48) angeordnet sind,
wobei die Anzeigeneinheit eine der Sensorelementanzahl entsprechende Menge von, Anzeigepunkten (28, 30, 32, 34) aufweist,
und die Recheneinheit (24) dazu vorgesehen ist, den Anzeigepunkten (28, 30, 32, 34) der Anzeigeeinheit (26) Sensorelemente (36, 38, 40) der Sensoreinheit (22) entlang zumindest einer Dimension (42, 44) derart zuzuordnen, dass den Anzeigepunkten jeweils ein Sensorelement zugeordnet ist,
**dadurch gekennzeichnet, dass**
zumindest ein erstes Sensorelement eine Signalerzeugungselektrode (62) und zumindest ein zweites Sensorelement eine Messelektrode (62) bildet, wobei die Signalerzeugungselektrode (64) zu einem Erzeugen eines Messsignals (20), Insbesondere eines Wechselsignals, vorgesehen ist und die Messelektrode (62) zu einem Messen des Messsignals 20.

2. Ortungsvorrichtung nach Anspruch 1, **dadurch gekennzeichnet, dass** die unterschiedlichen Sensorelemente der Sensoreinheit sowohl als Messsensor als auch als Signalerzeugungssensor ausgebildet sind, wobei die Funktionsweise der einzelnen Sensorelemente von ihrer Ansteuerung und/oder einer Verschaltung der einzelnen Sensorelemente abhängig ist.

3. Ortungsvorrichtung nach Anspruch 1, **dadurch gekennzeichnet, dass** eine Anzahl von Sensorelementen (36, 38, 40) der Sensoreinheit (22) im Wesentlichen gleich einer Anzahl von Anzeigepunkten (28, 30, 32, 34) der Anzeigeeinheit (26) in zumindest einer Dimension (42, 44) ist.

4. Ortungsvorrichtung nach einem der vorhergehenden Ansprüche, **dadurch gekennzeichnet, dass** die Anzeigeeinheit (26) von einer zweidimensionalen Anzeigeeinheit (26) gebildet ist, die dazu vorgesehen ist, ein Abbild (46) des Untersuchungsobjekts (16) in zwei Dimensionen (42, 44) auszugeben.

5. Ortungsvorrichtung nach einem der vorhergehenden Ansprüche, **dadurch gekennzeichnet, dass** die Recheneinheit (24) dazu vorgesehen ist, zumindest zwei Messwerte bei einer zweidimensionalen Erfassung mittels der Sensoreinheit (22) zu einem Wert entlang einer Dimension (42, 44) zusammenzufassen.

6. Ortungsvorrichtung nach Anspruch 1, **dadurch gekennzeichnet, dass** die Recheneinheit (24) dazu vorgesehen ist, die Sensorelemente (36, 38, 40) entlang zumindest einer Dimension (42, 44) nacheinander für eine Messung zu aktivieren.

7. Ortungsvorrichtung zumindest nach Anspruch 1, **dadurch gekennzeichnet, dass** die Recheneinheit (24) dazu vorgesehen ist, einen gleich bleibenden Abstand (50) zwischen zwei variierenden, aktivierten Sensorelementen (36, 38, 40) einzustellen.

8. Ortungsvorrichtung zumindest nach Anspruch 1, **dadurch gekennzeichnet, dass** die Recheneinheit (24) dazu vorgesehen ist, einen variierenden Abstand (52) zwischen zwei zumindest teilweise variierenden, aktivierten Sensorelementen (36, 38, 40) einzustellen.

9. Verfahren zum Betrieb einer Ortungsvorrichtung, insbesondere einer Ortungsvorrichtung nach zumindest einem der vorhergehenden Ansprüche, bei dem einer Vielzahl von Anzeigepunkten (28, 30, 32, 34) einer Anzeigeeinheit (26) der Ortungsvorrichtung eine der Anzeigepunkte enzahl entsprechende menge von Sensorelementen (36, 38, 40) einer Sensoreinheit (22) einer Ortungseinheit (14) der Ortungsvorrichtung entlang zumindest einer Dimension (42, 44) zugeordnet werden, **dadurch gekennzeichnet, dass** im Betrieb der Ortungseinheit (14) am Eingang eines Messverstärkers eine Spannungskenngröße ermittelt wird, die ein Maß für eine kapazitive Verkopplung zwischen einem als Signalerzeugungselektrode (64) ausgebildeten Sensorelement (36) und einem als Messelektrode (62) ausgebildeten Sensorelement (38) ist.

10. Verfahren nach Anspruch 9, **dadurch gekennzeichnet, dass** ein Abbild (46) eines Untersuchungsobjekts (16) mittels der Anzeigeeinheit (26) entlang zumindest einer Dimension (42, 44) angezeigt wird.

11. Verfahren zumindest nach Anspruch 9, **dadurch gekennzeichnet, dass** ein zweidimensionales Abbild (46) des Untersuchungsobjekts (16) mittels der Anzeigeeinheit (26) angezeigt wird.

12. Verfahren zumindest nach Anspruch 9, **dadurch gekennzeichnet, dass** eine Orientierung (54) eines Gegenstands (18) mittels der Anzeigeeinheit (26) angezeigt wird.

13. Verfahren zumindest nach Anspruch 19, dadurch gekennzeiehnet, dass ein gleich bleibender Abstand (50) zwischen zwei variierenden, aktivierten Sensorelementen (36, 38, 40) einer Sensoreinheit (22) eingestellt wird.

14. Verfahren zumindest nach Anspruch 9, **dadurch gekennzeichnet, dass** ein variierender Abstand (52) zwischen zwei zumindest teilweise variierenden, aktivierten Sensorelementen (36, 38, 40) eingestellt wird.

15. Verfahren zumindest nach Anspruch 14, **dadurch gekennzeichnet, dass** mittels des variierenden Abstands (52) zwischen zwei zumindest teilweise variierenden, aktivierten Sensorelementen (36, 38, 40) eine Objekttiefe ermittelt wird.

## Claims

1. Position-finding apparatus, in particular a handheld position-finding device (12),
having a position-finding unit (14), which is intended to detect the presence of an item (18) arranged in an examination object (16) using a measurement signal (20) and has a sensor unit (22) and a computation unit (24),
and also having a display unit,
the sensor unit (22) having a multiplicity of sensor elements (36, 38, 40) which are arranged in a sensor array (48),
the display unit having an amount of display points (28, 30, 32, 34) which corresponds to the number of sensor elements,
and the computation unit (24) being intended to assign sensor elements (36, 38, 40) of the sensor unit (22) to the display points (28, 30, 32, 34) of the display unit (26) along at least one dimension (42, 44) such that one sensor element is assigned to each of the display points, **characterized in that**
at least one first sensor element forms a signal-generating electrode (64) and at least one second sensor element forms a measuring electrode (62), the signal-generating electrode (64) being intended to generate a measurement signal (20), in particular an alternating signal, and the measuring electrode (62) being intended to measure the measurement signal (20).

2. Position-finding apparatus according to Claim 1, **characterized in that** the different sensor elements of the sensor unit are in the form of both a measuring sensor and a signal-generating sensor, the method of operation of the individual sensor elements being dependent on their control and/or a connection of the individual sensor elements.

3. Position-finding apparatus according to Claim 1, **characterized in that** a number of sensor elements (36, 38, 40) of the sensor unit (22) is substantially the same as a number of display points (28, 30, 32, 34) of the display unit (26) in at least one dimension (42, 44).

4. Position-finding apparatus according to one of the preceding claims, **characterized in that** the display unit (26) is formed by a two-dimensional display unit (26) which is intended to output an image (46) of the examination object (16) in two dimensions (42, 44).

5. Position-finding apparatus according to one of the preceding claims, **characterized in that** the computation unit (24) is intended to combine at least two measured values during two-dimensional detection using the sensor unit (22) to form one value along one dimension (42, 44).

6. Position-finding apparatus according to Claim 1, **characterized in that** the computation unit (24) is intended to activate the sensor elements (36, 38, 40) in succession along at least one dimension (42, 44) for a measurement.

7. Position-finding apparatus at least according to Claim 1, **characterized in that** the computation unit (24) is intended to set a constant distance (50) between two varying activated sensor elements (36, 38, 40).

8. Position-finding apparatus at least according to Claim 1, **characterized in that** the computation unit (24) is intended to set a varying distance (52) between two at least partially varying activated sensor elements (36, 38, 40).

9. Method for operating a position-finding apparatus, in particular a position-finding apparatus according to at least one of the preceding claims, in which an amount, corresponding to the number of display points, of sensor elements (36, 38, 40) of a sensor unit (22) of a position-finding unit (14) of the position-finding apparatus are assigned to a multiplicity of display points (28, 30, 32, 34) of a display unit (26) of the position-finding apparatus along at least one dimension (42, 44), **characterized in that**, during operation of the position-finding unit (14), a voltage characteristic variable is determined at the input of a measuring amplifier, which characteristic variable is a measure of capacitive coupling between a sensor element (36) in the form of a signal-generating electrode (64) and a sensor element (38) in the form of a measuring electrode (62).

10. Method according to Claim 9, **characterized in that** an image (46) of an examination object (16) is displayed along at least one dimension (42, 44) using the display unit (26).

11. Method at least according to Claim 9, **characterized in that** a two-dimensional image (46) of the examination object (16) is displayed using the display unit (26).

12. Method at least according to Claim 9, **characterized in that** an orientation (54) of an item (18) is displayed using the display unit (26).

13. Method at least according to Claim 9, **characterized in that** a constant distance (50) is set between two varying activated sensor elements (36, 38, 40) of a sensor unit (22).

14. Method at least according to Claim 9, **characterized in that** a varying distance (52) is set between two at least partially varying activated sensor elements (36, 38, 40).

15. Method at least according to Claim 14, **characterized in that** an object depth is determined using the varying distance (52) between two at least partially varying activated sensor elements (36, 38, 40).

## Revendications

1. Dispositif de localisation, notamment appareil de localisation (12) guidé à la main ;
avec une unité de localisation (14) prévue pour détecter une présence d'un objet (18) disposé dans un objet à examiner (16) à l'aide d'un signal de mesure (20) et comportant une unité de détection (22) ainsi qu'une unité de calcul (24) ;
ainsi qu'avec une unité d'affichage ;
l'unité de détection (22) comportant une pluralité d'éléments de détection (36, 38, 40) disposés en batterie de capteurs (48) ;
l'unité d'affichage comportant une quantité de points d'affichage (28, 30, 32, 34) correspondant au nombre d'éléments de détection ; et
l'unité de calcul (24) étant prévue pour associer des éléments de détection (36, 38, 40) de l'unité de détection (22) aux points d'affichage (28, 30, 32, 34) de l'unité d'affichage (26) le long d'au moins une dimension (42, 44) de telle sorte qu'un élément de détection est respectivement associé aux points d'affichage ;
**caractérisé en ce que** :
au moins un premier élément de détection forme une électrode d'émission de signaux (64) et qu'au moins un deuxième élément de détection forme une électrode de mesure (62), l'électrode d'émission de signaux (64) étant prévue pour émettre un signal de mesure (20), notamment un signal alternatif, et l'électrode de mesure (62) étant prévue pour réaliser une mesure du signal de mesure (20).

2. Dispositif de localisation selon la revendication 1, **caractérisé en ce que** les différents éléments de détection de l'unité de détection prennent aussi bien la forme d'un capteur de mesure que d'un capteur d'émission de signaux, le fonctionnement des éléments de détection individuels dépendant de leur excitation et/ou du raccordement ou non-raccordement des éléments de détection individuels.

3. Dispositif de localisation selon la revendication 1, **caractérisé en ce qu'**un nombre d'éléments de détection (36, 38, 40) de l'unité de détection (22) est pour l'essentiel identique à un nombre de points d'affichage (28, 30, 32, 34) de l'unité d'affichage (26) dans au moins une dimension (42, 44).

4. Dispositif de localisation selon l'une quelconque des revendications précédentes, **caractérisé en ce que** l'unité d'affichage (26) est formée par une unité d'affichage (26) bidimensionnelle prévue pour produire une illustration (46) de l'objet à examiner (16) dans deux dimensions (42, 44).

5. Dispositif de localisation selon l'une quelconque des revendications précédentes, **caractérisé en ce que** l'unité de calcul (24) est prévue pour condenser au moins deux valeurs de mesure d'une détection bidimensionnelle à l'aide de l'unité de détection (22) en une valeur placée le long d'une dimension (42, 44).

6. Dispositif de localisation selon la revendication 1, **caractérisé en ce que** l'unité de calcul (24) est prévue pour activer les éléments de détection (36, 38, 40) le long d'au moins une dimension (42, 44) à la suite les uns des autres pour une mesure.

7. Dispositif de localisation au moins selon la revendication 1, **caractérisé en ce que** l'unité de calcul (24) est prévue pour régler une distance (50) invariable entre deux éléments de détection (36, 38, 40) activés variables.

8. Dispositif de localisation selon la revendication 1 au moins, **caractérisé en ce que** l'unité de calcul (24) est prévue pour régler une distance (52) variable entre deux éléments de détection (36, 38, 40) activés variant au moins en partie.

9. Procédé de fonctionnement d'un dispositif de localisation, notamment d'un dispositif de localisation selon au moins l'une quelconque des revendications précédentes, dans lequel une quantité d'éléments de détection (36, 38, 40), correspondant au nombre de points d'affichage, d'une unité de détection (22) d'une unité de localisation (14) du dispositif de localisation le long d'au moins une dimension (42, 44) est associée à une pluralité de points d'affichage (28, 30, 32, 34) d'une unité d'affichage (26) du dispositif de localisation, **caractérisé en ce qu'**en situation de fonctionnement de l'unité de localisation (14), une grandeur caractéristique de tension est calculée à l'entrée d'un amplificateur de mesure, ladite grandeur étant une mesure réalisée pour un couplage capacitif prévu entre un élément de détection (36) prenant la forme d'une électrode d'émission de signaux (64) et un élément de détection (38) prenant la forme d'une électrode de mesure (62).

10. Procédé selon la revendication 9, **caractérisé en ce qu'**une illustration (46) d'un objet à examiner (16) est affichée à l'aide de l'unité d'affichage (26) le long d'au moins une dimension (42, 44).

11. Procédé selon la revendication 9 au moins, **caractérisé en ce qu'**une illustration (46) bidimensionnelle de l'objet à examiner (16) est affichée à l'aide de l'unité d'affichage (26).

12. Procédé selon la revendication 9 au moins, **caractérisé en ce qu'**une orientation (54) d'un objet (18) est affichée à l'aide de l'unité d'affichage (26).

13. Procédé selon la revendication 9 au moins, **caractérisé en ce qu'**une distance (50) identique est réglée entre deux éléments de détection (36, 38, 40) activés variables d'une unité de détection (22).

14. Procédé selon la revendication 9 au moins, **caractérisé en ce qu'**une distance (52) variable est réglée entre deux éléments de détection (36, 38, 40) activés variant au moins en partie.

15. Procédé selon la revendication 14 au moins, **caractérisé en ce qu'**une profondeur d'objet est calculée à l'aide de la distance (52) variable prévue entre deux éléments de détection (36, 38, 40) activés variant au moins en partie.
